(19) Europäisches Patentamt

European Patent Office

Office européen des brevets

(11) **EP 1 174 769 B1**

(12) **EUROPEAN PATENT SPECIFICATION**

(45) Date of publication and mention
of the grant of the patent:
**13.12.2006 Bulletin 2006/50**

(51) Int Cl.:
***G03F 7/20*** *(2006.01)*

(21) Application number: **01305861.5**

(22) Date of filing: **06.07.2001**

(54) **Lithographic projection apparatus and lithographic device manufacturing method**

Lithographischer Projektionsapparat und lithographisches Verfahren zur Herstellung einer Vorrichtung

Appareil de projection lithographique et méthode lithographique de fabrication d'un dispositif

(84) Designated Contracting States:
**DE FR GB IT NL**

(30) Priority: **10.07.2000 EP 00202457**

(43) Date of publication of application:
**23.01.2002 Bulletin 2002/04**

(73) Proprietor: **ASML Netherlands B.V.**
**5504 DR Veldhoven (NL)**

(72) Inventors:
 • **Benschop, Jozef Petrus Henricus**
  **5501 EV Veldhoven (NL)**
 • **Noordman, Oscar Fransiscus Jozephus**
  **5616 HC Eindhoven (NL)**
 • **Renkens, Michael Jozefa Mathijs**
  **6162 JG Geleen (NL)**

 • **Loopstra, Erik Roelof**
  **5591 PJ Heeze (NL)**
 • **Banine, Vadim Yevgenyevich**
  **5704 NK Helmond (NL)**
 • **Moors, Johannes Hubertus Josephina**
  **5503 LA Helmond (NL)**
 • **van Dijsseldonk, Antonius Johannes Josephus**
  **5527 BH Hapert (NL)**

(74) Representative: **Leeming, John Gerard**
 **J.A. Kemp & Co.,**
 **14 South Square,**
 **Gray's Inn**
 **London WC1R 5LX (GB)**

(56) References cited:
**EP-A- 0 421 746      EP-A- 0 987 601**
**EP-A- 1 017 086      EP-A- 1 041 607**
**WO-A1-99/25011      US-A- 5 524 039**

EP 1 174 769 B1

**Description**

The present invention relates to a lithographic projection apparatus comprising:

- a radiation system for supplying a projection beam of radiation having a propagation direction;
- a support structure for supporting the radiation system;
- a support structure for supporting patterning means, the patterning means serving to pattern the projection beam according to a desired pattern;
- a substrate table for holding a substrate;
- a projection system for projecting the patterned beam onto a target portion of the substrate; and
- a support structure for supporting the projection system.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. An example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-adressable surface. The required matrix addressing can be performed using suitable electronic means. More information on such mirror arrays can be gleaned, for example, from US 5,296,891 and US 5,523,193. In the case of a programmable mirror array, the said support structure may be embodied as a frame or table, for example, which may be fixed or movable as required.
- A programmable LCD array. An example of such a construction is given in US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Twin stage lithographic apparatus are described, for example, in US 5,969,441 and WO 98/40791.

During exposure, the radiation system supplies a projection beam of radiation to irradiate a portion of the mask (or other patterning means) and the projection system images the irradiated portion of the mask onto a target portion of the substrate. It is important that the total plane of the mask is irradiated with an qual dose. Variations in the intensity of the projection beam over the plane of the mask will cause a variation in the dose and hence a variation in the quality of the imaged target portions on the substrate. Variations in the intensity cause the critical dimension (i.e. the line width of the imaged lines) to vary, which is not wanted. Substrates having such a variation of the critical dimension may be rejected during a quality control in the manufacturing process. If the intensity of irradiation is higher than a nominal intensity at a certain portion of the mask, the critical dimension of the images projected from that portion will be smaller than when the nominal intensity is used at that portion. EP-A-0421 746 describes the detection of the relative positional changes between an illumination beam and an exposure zone on a substrate. A drift in a positional reference shifts the exposure time distribution. The measuring of the change in position of the beam is carried out by direct measurement on the beam itself.

WO 99/25011 discloses a lithographic projection apparatus according to the preamble of claim 1.

It is an object of the invention to alleviate, at least partially, the above problems. More particularly, it is an object of the invention to provide an apparatus with a very low intensity variation over the plane of the mask (or other patterning means). Accordingly, the present invention provides an apparatus according to the opening paragraph, characterized in that the lithographic projection apparatus further comprises measuring means constructed and arranged to measure a movement of the projection beam substantially perpendicular to its propagation direction with respect to the projection system by measuring the relative movement of the radiation system support structure and the projection system support structure, and control means constructed and arranged to control the intensity of said projection beam on a target portion of the substrate in response to an output from said measuring means.

It is determined that one of the main causes of variations of the intensity of irradiation of the mask is a movement of the projection beam perpendicular to its propagation direction. This movement may be caused by the radiation system mechanically moving with respect to the projection system or the source of the projection beam moving with respect to the projection system. The latter can, for example, be the case if a plasma source is used. The plasma that radiates the projection beam can be moving perpendicular to its propagation direction. The movements of the plasma will be projected through the radiation system of the lithographic apparatus and will cause the projection beam to move with respect to the projection system.

The invention can be advantageously used in a lithographic projection apparatus wherein said support structure is movable in a scanning direction that is substantially perpendicular to the propagation direction, and said measuring means is adapted to measure movements of said projection beam in a direction corresponding to said scanning direction.

A lithographic projection apparatus as described in the previous paragraph can be very sensitive to movements in said scanning direction because the relative movement of the projection beam with respect to the mask (or other patterning means) is determined by the movement of the mask plus the movement of the projection beam. The relative movement of the projection beam with respect to the mask will determine the intensity of irradiation on a portion of the mask. If for example, the mask moves in the same direction as the projection beam the relative movement of that beam with respect to the mask will be low and consequently the intensity of the irradiation higher on that portion of the mask. If, the other way around, the projection beam moves in the opposite direction to the mask the relative movement will be high and the intensity of the irradiation lower on that portion of the mask. The control means may be adapted to control the movements of said support structure and said substrate table in the scanning direction, because by adjusting the speed of the mask and the substrate table the received dose of said projection beam on a target portion of said substrate can be controlled.

Control means can be connected to the said measuring means and to adjustment means for adjusting the intensity of the projection beam in response to an adjustment signal from said control means. The control means can calculate an adjusted radiation intensity in response to information of the measuring means about the movement of the projection beam with respect to the projection system. This adjusted radiation intensity (e.g. adjustment signal) will be sent to a source of the projection beam, which subsequently adjusts the intensity of that beam. If the projection beam is pulsed (e.g. the source radiates in pulses) said control means can adjust the repetition rate or frequency of the pulses to adjust the intensity of that beam. Alternatively, said control means may be constructed and arranged to adjust the energy per pulse.

If mechanical movements between the radiation system and the projection system cause the movements of the projection beam, the measuring means may be adapted to measure mechanical movements. It may be advantageous to use acceleration measuring means for such measurements. A direct mechanical connection between the radiation system and the projection system for the measuring means may be avoided in this way.

If a movement of the source of the projection beam causes the movements of the projection beam the measuring means may comprise intensity measuring means for measuring the intensity of that beam. This can be done by using two or more light intensity measuring sensors, which are located at a fixed place in the projection beam and are used for a differential measurement. If the light intensity at a first sensor is increasing relative to the light intensity received by a second sensor the projection beam will be moving in the direction of the first sensor.

The said measuring means can be connected to a source measuring means and said source measuring means can measure movements of the source of said projection beam with respect to a reference point. The source measuring means can be placed nearby the source (e.g. a plasma) and the results of the source measuring means can be processed in the control means such that the movements of the projection beam with respect to the projection system can be calculated.

In the case of a pulsed source, the measuring means will give a measurement signal when the source of the projection beam emits a pulse. The position of the projection beam during each pulse will be measured and a future position of the projection beam with respect to the projection system can be determined by the control means, if said movement is an oscillating movement. For this purpose the control means may be provided with calculating means for calculating a future position of said projection beam. When the oscillating movement is known and the calculating means can calculate a future position the control means can predict the position of the projection beam for a subsequent pulse. The said subsequent pulse will be triggered at a moment when the projection beam is at a required position with respect to the projection system. For the first pulses irradiated by the source the oscillation movement will not be known and therefore these pulses will be positioned randomly. To alleviate a possible non-uniformity in the intensity caused by the first pulses, a data storage device connected to said measuring means and said control means can be used. The data storage device will store information about the intensity and position of the projection beam during the randomly radiated first pulses. When the oscillating movement is known, for example after the first five pulses are radiated, this data can be used to trigger the next pulses for the projection beam such that any intensity variation during the first pulses is compensated during the following pulses.

According to a further aspect of the invention there is provided a device manufacturing method comprising the steps of:

- providing a substrate that is at least partially covered by a layer of radiation-sensitive material;
- providing a projection beam of radiation, having a propagation direction, using a radiation system supported by a support structure;
- using patterning means to endow the projection beam with a pattern in its cross-section;
- projecting the patterned beam of radiation onto a target portion of the layer of radiation-sensitive material using a projection system supported by a support structure,

characterised in that movements of the radiation system support structure with respect to the projection system support structure are measured by measuring means and the output of the measuring means is transmitted to control means for adjusting the intensity of said projection beam in response to an output from said measuring means.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20nm), as well as particle beams, such as ion beams or electron beams.

The invention and its attendant advantages will be further elucidated with the aid of exemplary embodiments and the accompanying schematic drawings, whereby:

Figure 1 depicts a lithographic projection apparatus according to the invention;

Figure 2 depicts a radiation system for use in a lithographic projection apparatus according to the invention.

Figure 3 depicts a lithographic projection apparatus according to the invention, where the control means comprise actuators for adjusting the position of a support frame for holding the radiation system and a source for providing a projection beam.

Embodiment 1

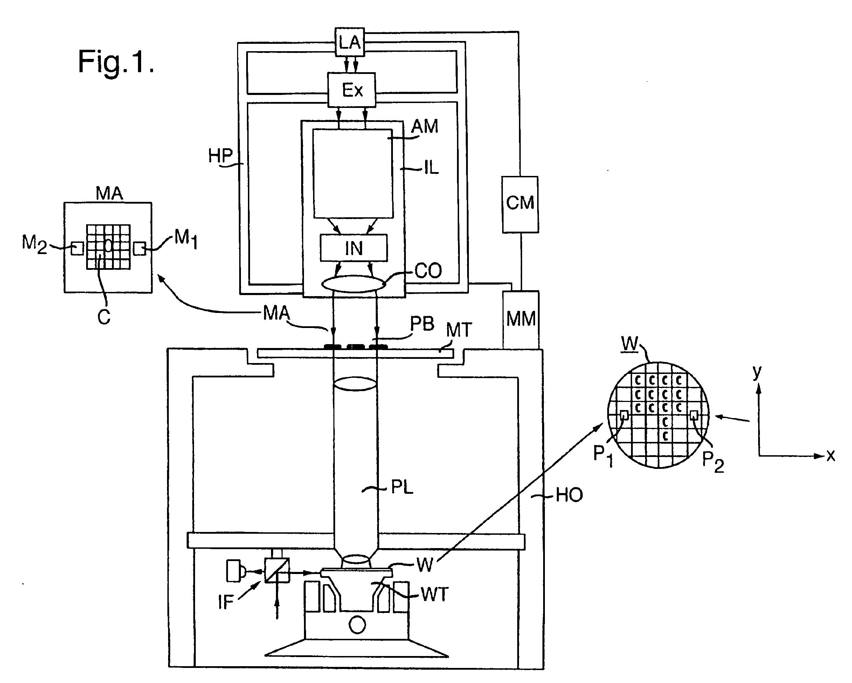

Figure 1 schematically depicts a lithographic projection apparatus according to a particular embodiment of the invention. The apparatus comprises:

a radiation system Ex, IL, for supplying a projection beam PB of radiation (e.g. UV radiation with a wavelength of 365 nm, 248 nm, 193 nm or 157 nm, or EUV radiation, X rays, electrons or ions). In this particular case, the radiation system also comprises a radiation source LA, and the radiation system as well as the source LA are rigidly fixed to a support frame HP;

a first object table (mask table) MT provided with a mask holder for holding a mask MA (e.g. a reticle), and connected to first positioning means for accurately positioning the mask with respect to item PL;

a second object table (substrate table) WT provided with a substrate holder for holding a substrate W (e.g. a resist-coated silicon wafer), and connected to second positioning means for accurately positioning the substrate with respect to item PL;

a projection system ("lens") PL (e.g. a lens or catadioptric system, or a mirror group) for imaging an irradiated portion of the mask MA onto a target portion C (e.g. comprising one or more dies) of the substrate W, and rigidly fixed to a support frame HO.

As here depicted, the apparatus is of a transmissive type (i.e. has a transmissive mask). However, in general, it may also be of a reflective type, for example (with a reflective mask). Alternatively, the apparatus may employ another kind of patterning means, such as a programmable mirror array of a type as referred to above.

The source LA (*e.g.* a Hg lamp or excimer laser, a laser-induced plasma or discharge plasma source, or a wiggler/undulator situated around the path of an electron beam in a storage ring or synchrotron) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, or for example a laser-produced plasma source), but that it may also be remote from the lithographic projection apparatus and separated from the support frame HP, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (coarse positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

In step mode, the mask table MT is kept essentially stationary, and an entire mask image is projected in one go (*i.e.*

a single "flash") onto a target portion C. The substrate table WT is then shifted in the x and/or y directions so that a different target portion C can be irradiated by the beam PB;

In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or 1/5). In this manner, a relatively large target portion C can be exposed, without having to compromise on resolution.

According to the invention measuring means MM are used for measuring movements of the projection beam PB with respect to the projection system PL. If these movements are caused by mechanical movements of the source LA and the radiation system Ex, IL with respect to the projection system PL (due to, for instance, a movement of the support frame HP), these movements can be measured by measuring the movements of the support frame HP with respect to the support frame HO with measuring means MM (e.g. interferometers, capacitive sensors, optical sensors or pneumatic sensors). Alternatively, one could use measuring means for measuring the acceleration of the frame HP with respect to the projection system PL.

A time dependent relative movement Mr (t) of the mask with respect to the projection beam PB in a step-and-scan apparatus is given by:

$$Mr\ (t) = Mm\ (t) - Mpb\ (t),$$

in which it is assumed that if the movement of the projection beam Mpb (t) and of the mask Mm (t) are in the same direction, the movement of the projection beam Mpb (t) gets a plus sign and when it is in the opposite direction it gets a minus sign. The movement of the mask Mm (t) has a predetermined value and the movement of the projection beam Mpb (t) is measured by the measuring means MM connected to a control means CM. Both movements are measured with respect to the projection system PL.

The lithographic projection apparatus according to the first embodiment comprises a pulsed source LA. Control means CM can calculate an adjustment of the repetition rate of the pulsed source LA to adjust the intensity of the projection beam PB in response to a calculated relative movement, by the following equation:

$$fl(t) \quad = fln \times [\ Mr(t)\ /\ Mm(t)]$$

$$= fln \times [\ 1 - Mpb\ (t)\ /\ Mm\ (t)],$$

in which fl (t) is the repetition rate of the source LA as controlled by the control means CM and fln is the nominal repetition rate of the source LA (e.g. a laser). If one would like to adjust the time interval $\Delta$ t between the pulses in response to a measured movement Mpb of the projection beam PB with respect to the projection system PL the following equation can be used:

$$\Delta\ t\ (t) = \Delta\ t\ 0 \times [\ 1 + Mpb\ (t)\ /\ Mm\ (t)],$$

in which $\Delta$ t (t) is the time between the pulse of the source at time t and the next pulse of the source, and $\Delta$ t 0 = 1 / fln. In this equation it is assumed that the movement of the projection beam PB does not change very much between the pulses i.e. that fln is much larger than the frequency of an oscillating movement of the projection beam PB with respect to the projection system PL.

Another possibility for adjusting the radiated intensity of the projection beam PB is adjustment of the energy per pulse by the control means CM in response to an measurement signal from the measurement means MM. The following equation shows how the energy per pulse can be adjusted to compensate for a movement of the projection

beam PB:

$$El\,(t) = Eln \times [\; 1 - Mpb\,(t)\,/\,Mm\,(t)],$$

wherein El (t) is the energy per pulse at time (t) and Eln is the nominal laser energy per pulse.

Embodiment 2

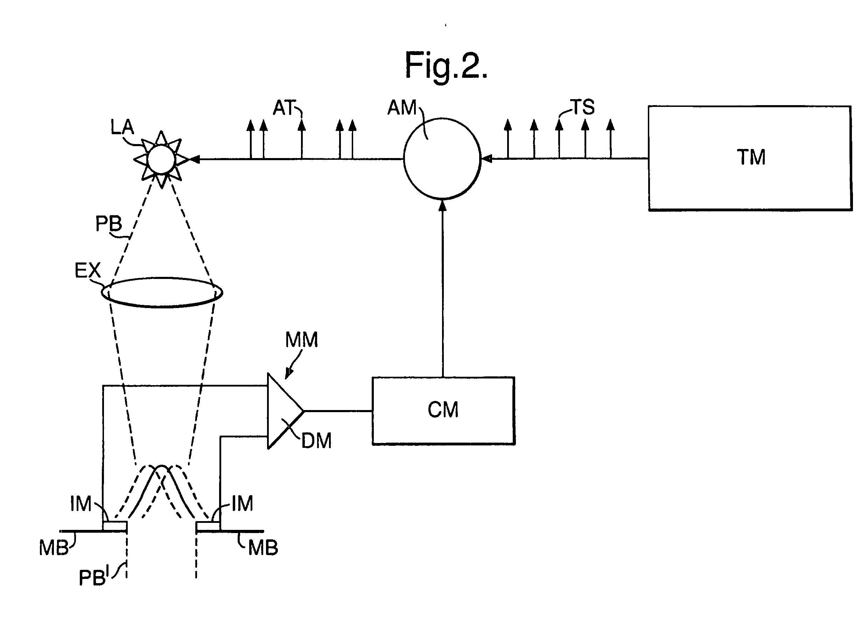

Figure 2 depicts a radiation system according to a second embodiment of the invention, which radiation system can be used in a lithographic apparatus according to embodiment 1. The radiation system comprises:

- a pulsed source of radiation LA which produces a projection beam of radiation PB such as UV radiation (e.g. with a wavelength of 365 nm, 248 nm, 193 nm, or 157 nm), or EUV radiation;
- beam shaping optics EX for forming a projection beam PB' with a required intensity and direction;
- masking means MB for defining the form of the projection beam PB';
- measuring means MM, comprising a pair of intensity measuring sensors IM and comparison means DM;
- control means CM; and
- pulse adjustment means AM for adjusting the pulse triggering signal TS from the pulse triggering means TM.

The source LA can be located away from the lithographic projection apparatus for safety or contamination reasons and the projection beam PB can be supplied to the apparatus through a light guide. The projection beam PB will traverse the beam shaping optics EX to the masking means MB which can partly obscure the beam PB so as to have, at the area of a (non-depicted) mask (or other patterning means), a rectangular cross-section of that beam PB. Subsequently the projection beam PB' which has a required form and direction will be projected upon the mask.

The measuring means MM can be used to measure a movement of the projection beam PB with respect to the masking means MB. The intensity measuring sensors IM will give an intensity signal in response to the received radiation from the source LA, and the comparison means DM will compare the intensity signals from both intensity measuring sensors IM with each other, such that a movement of the projection beam PB with respect to the masking means MB can be determined. For example, if the projection beam PB moves toward one of the two intensity measuring sensors IM (e.g. comprising CCD arrays, photodiodes or photomultipliers) the comparison means DM will notice an increase in the measured intensity at the said one intensity measuring sensor IM and a decrease in the measured intensity at the other intensity measuring sensor IM. The comparison means DM can determine the position and the movement of the projection beam PB with respect to the masking means MB, and give a signal corresponding to said position and movement to the control means CM. The control means CM can calculate an adjusted radiation intensity and can send a signal to the adjustment means AM to adjust the pulses TS, which come from the pulse trigger means TM, into adjusted pulses AT. The pulses AT trigger a pulse of radiation from the source LA to form projection beam PB.

If a pulsed source LA is used, the control means CM will only get a measurement signal from the measuring means MM when the source LA radiates a pulse; between those pulses no movement or position can be measured because there is no radiation on the intensity measuring sensors IM. However, it can often be expected that the movement of the projection beam PB will be an oscillating movement, such that after the initial pulses the oscillation of that beam PB can be determined and future positions of that beam PB can be calculated. The control means CM can calculate a future position of the projection beam PB and can adjust the pulses TS such that the mask is irradiated with a uniform intensity. Information describing the non-uniform intensity caused by the first irradiated pulses (i.e. the pulses necessary to determine the oscillation) can be stored in a data storage device by storing data with regard to the intensity and the position of the projection beam PB per pulse. The data storage device is connected to the measuring means MM and the control means CM. Later on, when the oscillation is determined, the data can be retrieved from the data storage device and can be used by the control means CM to calculate an adjusted timing of the pulses for the adjustment means AM, such that subsequent pulses can compensate for non-uniformity caused by the first irradiated pulses.

Embodiment 3

In a third embodiment according to the invention, the measuring means (e.g. the measuring means MM in figure 2) may comprise source measuring means located near the source of radiation LA to measure movements of that source LA. The data from the source measuring means MM need to be converted to data for movement of the projection beam PB by a calculating device, which may be comprised by control means CM. The control means CM can calculate an adjusted radiation intensity in response to a measurement signal from the measuring means MM and can send a signal to the adjustment means AM to adjust the pulses TS, which come from the pulse trigger means TM, into adjusted pulses AT. The latter can be done similar to the methods described in embodiment 1 and 2. It must be understood that when the measuring means MM comprises a source measuring means as described above, the intensity measuring sensors IM and the comparison means DM of embodiment 2 may be left out of the embodiment.

Embodiment 4

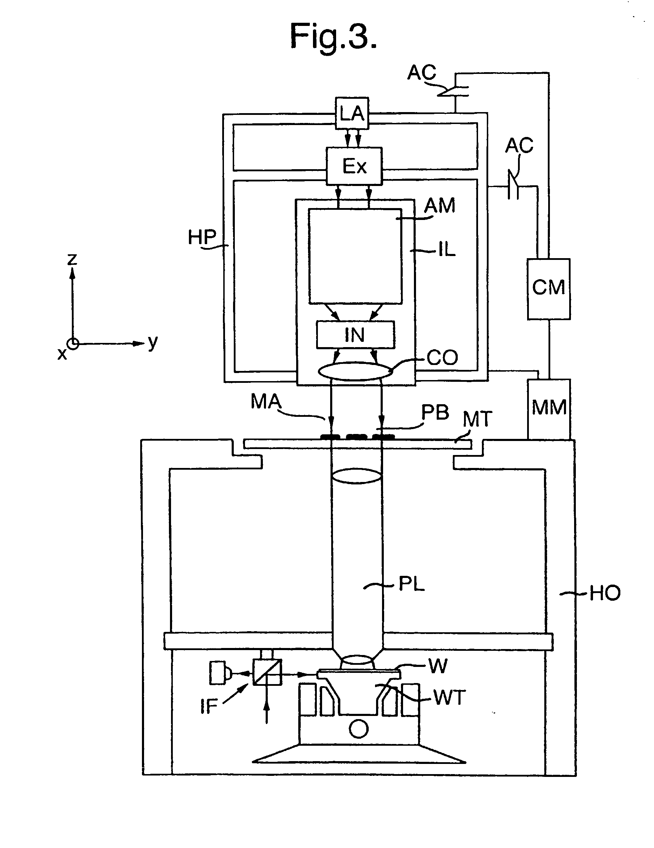

In a fourth embodiment according to the invention, which is illustrated in Figure 3 and which may be the same as the first embodiment save as described below, actuators AC are introduced to provide position adjustments of the frame HP with respect to the frame HO. The control means CM are adapted to control the actuators AC. Said position adjustments comprise at least adjustments in a direction substantially perpendicular to the direction of propagation of the projection beam PB. Generally, the frame HO is supported by airmounts to alleviate the effect of, for instance, vibrations of a floor supporting the lithographic projection apparatus. In this embodiment the frame HP is, just as the frame HO, supported by airmounts (not shown in Figure 3) and the actuators AC may be, for instance, airmount actuators. A movement of the frame HO will in principle cause a movement of the frame HP relative to the frame HO. Such a movement will, in principle, cause a movement of the projection beam PB with respect to the projection system PL, and as explained above this may lead to exposure dose variations. The control means CM are, in this embodiment, adapted to provide signals to the actuators AC such that the frame HP substantially follows the movement of the frame HO. In principle the position of the projection beam PB with respect to the projection system PL is then substantially stable in time and the problem of exposure dose variations is alleviated.

Embodiment 5

In a fifth embodiment which may be the same as the first and fourth embodiment save as described below, the source LA and the radiation system Ex, IL are rigidly fixed to two corresponding, separate support frames, each frame adjustable in position by means of actuators. Such a modular set-up of support frames may be more practical that the use of a single support frame HP, in view of maintenance. It is then possible to adapt the measuring means MM to measure the position of said two support frames with respect to the frame HO and to adapt the control means CM to provide signals to actuators for adjusting the position of at least one of said two support frames such as to follow a movement of the frame HO. Similarly, one or more individual optical elements comprised by the radiation system Ex, IL, and traversed by the projection beam, such as for example mirrors, can be made adjustable in position by means of corresponding optical-element position-actuators. Coefficients relating changes of position of the projection beam PB relative to the projection system PL to corresponding adjustments of position of said individual optical elements can be calculated and stored in a table. The control means CM are then adapted to calculate, using said coefficients, the required adjustments of position of at least one of said individual optical elements and to provide corresponding signals for corresponding optical-element position-actuators, such that the position of the projection beam PB with respect to the projection system PL is substantially stable in time.

Whilst specific embodiments of the invention have been described above, it will be appreciated that the invention may be practiced otherwise than as described. The description is not intended to limit the invention which is defined by the following claims.

**Claims**

1.  A lithographic projection apparatus comprising:

    - a radiation system (Ex,IL) for supplying a projection beam (PB) of radiation having a propagation direction;
    - a support structure (HP) for supporting the radiation system (Ex,IL);
    - a support structure (MT) for supporting patterning means (MA), the patterning means serving to pattern the projection beam according to a desired pattern;
    - a substrate table (WT) for holding a substrate (W);
    - a projection system (PL) for projecting the patterned beam onto a target portion (C) of the substrate;
    - a support structure (HO) for supporting the projection system (PL); and
    - measuring means (MM) constructed and arranged to measure a movement of the projection beam (PB) substantially perpendicular to its propagation direction with respect to the projection system (PL) by measuring the relative movement of the radiation system support structure (HP) and the projection system support structure (HO), **characterised by** comprising control means (CM) constructed and arranged to control the intensity of said projection beam on a target portion of the substrate in response to an output from said measuring means.

2. A lithographic projection apparatus according to claim 1, wherein said support structure (MT) and said substrate table (WT) are movable in a scanning direction that is substantially perpendicular to the propagation direction, and said measuring means (MM) is adapted to measure movements of said projection beam (PB) in a direction corresponding to said scanning direction.

3. A lithographic apparatus according to claim 2, wherein said control means (CM) is adapted to control the movement of said support structure (MT) and said substrate table (WT) in the scanning direction.

4. A lithographic projection apparatus according to claim 1, wherein said projection beam (PB) comprises pulses (TS) of radiation being irradiated at a repetition frequency and said control means (CM) is adapted to adjust said repetition frequency.

5. A lithographic projection apparatus according to claim 1, wherein said projection beam (PB) of radiation comprises pulses (TS) of radiation having an energy per pulse and said control means (CM) is adapted to adjust the energy per pulse.

6. A lithographic projection apparatus according to claim 1, wherein said control means (CM) comprises at least one actuator (AC) for adjusting the position with respect to a reference point associated with the projection system of at least one component selected from the group of components comprising the radiation system (Ex,IL), a source (LA) for providing a projection beam to the radiation system, an optical element (PL) of the radiation system, a support frame (HO) for holding the radiation system, a support frame (HP) for holding said source, and a support frame (HO) for holding the radiation system and said source.

7. A lithographic projection apparatus according to any of the claims 1-6, wherein said measuring means (MM) is adapted to measure a movement with respect to a reference point associated with said projection system of at least one component selected from the group of components comprising the radiation system (Ex,IL), a source (LA) for providing a projection beam to the radiation system, a support frame (HO) for holding the radiation system, a support frame (HP) for holding said source, and a support frame (HO) for holding the radiation system and said source.

8. A lithographic projection apparatus according to any of the claims 1-7, wherein said measuring means (MM) comprises acceleration measuring means.

9. A lithographic projection apparatus according to any of the claims 1-3, wherein said measuring means (MM) comprises intensity measuring means (IM) for measuring the intensity of said projection beam.

10. A lithographic projection apparatus according to any of the claims 6-9, wherein said control means (CM) is adapted to calculate a future position of said projection beam and has a pulse triggering signal (TM) as output to trigger a projection beam from a pulsed source of radiation.

11. A lithographic projection apparatus according to claim 10, wherein said apparatus comprises a data storage device connected to said measuring means (MM) and said control means (CM), for storing information about the intensity and the position of said projection beam during already radiated pulses.

12. An apparatus according to any of the claims 1-11, wherein the support structure comprises a mask table (MT) for holding a mask (MA).

13. An apparatus according to any of the claims 1-12, wherein the radiation system (Ex,IL) comprises a radiation source (LA).

14. A device manufacturing method comprising the steps of:

   - providing a substrate (W) that is at least partially covered by a layer of radiation-sensitive material;
   - providing a projection beam (PB) of radiation having a propagation direction using a radiation system (Ex,IL) supported by a support structure (HP);
   - using patterning means (MA) to endow the projection beam with a pattern in its cross-section;

- projecting the patterned beam of radiation onto a target portion (C) of the layer of radiation-sensitive material using a projection system (PL) supported by a support structure (HO),
- measuring movements of the radiation system support structure (HO) with respect to the projection system support structure (HP) by measuring means (MM);

**characterized by** transmitting the output of the measuring means to a control means (CM) arranged to adjust the intensity of said projection beam in response to an output from said measuring means.

**Patentansprüche**

1. Lithographische Projektionsvorrichtung, mit:

    - einem Strahlungssystem (Ex, IL) zum Bereitstellen eines Projektionsstrahls (PB) aus Strahlung mit einer Ausbreitungsrichtung;
    - einer Halteeinrichtung (HP) zum Halten des Strahlungssystems (Ex, IL);
    - einer Halteeinrichtung (MT) zum Halten von Musteraufbringungseinrichtungen (MA), wobei die Musteraufbringungseinrichtungen dazu dienen, den Projektionsstrahl gemäß einem gewünschten Muster zu mustern;
    - einem Substrattisch (WT) zum Halten eines Substrats (W);
    - einem Projektionssystem (PL) zum Projizieren des gemusterten Strahls auf einen Zielabschnitt (C) des Substrats;
    - einer Halteeinrichtung (HO) zum Halten des Projektionssystems (PL); und
    - Messeinrichtungen (MM), die konstruiert und angeordnet sind, um eine Bewegung des Projektionsstrahls (PB) zu messen, die im wesentlichen senkrecht zu seiner Ausbreitungsrichtung im Hinblick auf das Projektionssystem (PL) verläuft, indem die relative Bewegung der Halteeinrichtung (HP) für das Strahlungssystem und der Halteeinrichtung (HO) für das Projektionssystem gemessen wird, **dadurch gekennzeichnet, dass** Steuereinrichtungen (CM) vorgesehen sind, die konstruiert und angeordnet sind, um die Intensität des Projektionsstrahls auf einen Zielabschnitt des Substrats als Reaktion auf einen Ausgang der Messeinrichtungen steuern zu können.

2. Lithographische Projektionsvorrichtung nach Anspruch 1, wobei die Halteeinrichtung (MT) und der Substrattisch (WT) in eine Scan-Richtung bewegbar sind, die im wesentlichen senkrecht zu der Ausbreitungsrichtung ist, und wobei die Messeinrichtungen (MM) Bewegungen des Projektionsstrahls (PB) in eine Richtung, die der Scan-Richtung entspricht, messen.

3. Lithographische Vorrichtung nach Anspruch 2, wobei die Steuereinrichtungen (CM) die Bewegung der Halteeinrichtung (MT) und des Substrattisches (WT) in die Scan-Richtung steuern.

4. Lithographische Projektionsvorrichtung nach Anspruch 1, wobei der Projektionsstrahl (PB) Strahlungspulse (TS) aufweist, die mit einer Wiederholfrequenz ausgestrahlt werden, und die Steuereinrichtungen (CM) diese Wiederholfrequenz anpassen.

5. Lithographische Projektionsvorrichtung nach Anspruch 1, wobei der Projektionsstrahl (PB) aus Strahlung Strahlungspulse (TS) mit einer Energie pro Puls aufweist, und die Steuereinrichtungen (CM) die Energie pro Puls anpassen.

6. Lithographische Projektionsvorrichtung nach Anspruch 1, wobei die Steuereinrichtungen (CM) wenigstens eine Betätigungseinrichtung (AC) zum Anpassen der Position im Hinblick auf einen Referenzpunkt umfassen, der dem Projektionssystem wenigstens einer Komponente zugeordnet ist, die aus der Komponentengruppe bestehend aus dem Strahlungssystem (Ex, IL), einer Quelle (LA) zum Bereitstellen eines Projektionsstrahls zu dem Strahlungssystem, einem optischen Element (PL) des Strahlungssystems, einem Halterahmen (HO) zum Halten des Strahlungssystems, einem Halterahmen (HP) zum Halten der Quelle und einem Halterahmen (HO) zum Halten des Strahlungssystems und der Quelle ausgewählt worden ist.

7. Lithographische Projektionsvorrichtung nach einem der Ansprüche 1-6, wobei die Messeinrichtungen (MM) eine Bewegung im Hinblick auf einen Referenzpunkt messen, der dem Projektionssystem wenigstens einer Komponente zugeordnet ist, die aus der Komponentengruppe bestehend aus dem Strahlungssystem (Ex, IL), einer Quelle (LA) zum Bereitstellen eines Projektionsstrahls zu dem Strahlungssystem, einem Halterahmen (HO) zum Halten des Strahlungssystems, einem Halterahmen (HP) zum Halten der Quelle und einem Halterahmen (HO) zum Halten des Strahlungssystems und der Quelle ausgewählt worden ist.

**8.** Lithographische Projektionsvorrichtung nach einem der Ansprüche 1-7, wobei die Messeinrichtungen (MM) Beschleunigungsmessmittel umfassen.

**9.** Lithographische Projektionsvorrichtung nach einem der Ansprüche 1-3, wobei die Messeinrichtungen (MM) Intensitätsmessmittel (IM) zum Messen der Intensität des Projektionsstrahls umfassen.

**10.** Lithographische Projektionsvorrichtung nach einem der Ansprüche 6-9, wobei die Steuereinrichtungen (CM) eine zukünftige Position des Projektionsstrahls berechnen und ein Pulsauslösesignal (TM) als Ausgang zum Auslösen eines Projektionsstrahls von einer gepulsten Strahlungsquelle aufweisen.

**11.** Lithographische Projektionsvorrichtung nach Anspruch 10, wobei die Vorrichtung ein Datenspeicherelement aufweist, das mit den Messeinrichtungen (MM) und den Steuereinrichtungen (CM) verbunden ist, um Daten über die Intensität und die Position des Projektionsstrahls während bereits ausgestrahlter Pulse zu speichern.

**12.** Vorrichtung nach einem der Ansprüche 1-11, wobei die Halteeinrichtung einen Maskentisch (MT) zum Halten einer Maske (MA) umfasst.

**13.** Vorrichtung nach einem der Ansprüche 1-12, wobei das Strahlungssystem (Ex, IL) eine Strahlungsquelle (LA) umfasst.

**14.** Verfahren zur Herstellung von Bauelementen, das folgende Schritte umfasst:

- Bereitstellen eines Substrats (W), das zumindest teilweise von einer Schicht aus strahlungsempfindlichem Material bedeckt ist;
- Bereitstellen eines Projektionsstrahls (PB) aus Strahlung, der sich unter Verwendung eines Strahlungssystems (Ex, IL), das von einer Halteeinrichtung (HP) gehalten wird, in eine Ausbreitungsrichtung bewegt;
- Verwenden von Musteraufbringungseinrichtungen (MA), um den Projektionsstrahl in seinem Querschnitt mit einem Muster zu versehen;
- Projizieren des gemusterten Strahls aus Strahlung auf einen Zielabschnitt (C) der Schicht aus strahlungsempfindlichem Material unter Verwendung eines Projektionssystems (PL), das von einer Halteeinrichtung (HO) gehalten wird,
- Messen von Bewegungen der Halteeinrichtung (HO) des Strahlungssystems im Hinblick auf die Halteeinrichtung (HP) des Projektionssystems mittels Messeinrichtungen (MM);

**gekennzeichnet durch** Weiterleiten des Ausgangs der Messeinrichtungen zu einer Steuereinrichtung (CM), welche die Intensität des Projektionsstrahls als Reaktion auf einen Ausgang von den Messeinrichtungen anpasst.

## Revendications

**1.** Appareil de projection lithographique, comportant :

- un système de rayonnement (Ex, IL) pour délivrer un faisceau de projection (PB) de rayonnement ayant une direction de propagation ;
- une structure de support (HP) pour supporter le système de rayonnement (Ex, IL) ;
- une structure de support (MT) pour supporter des moyens de mise en forme (MA), les moyens de mise en forme servant à mettre en forme le faisceau de projection conformément à un motif voulu ;
- une table de substrat (WT) pour tenir un substrat (W) ;
- un système de projection (PL) pour projeter le faisceau mis en forme sur une partie cible (C) du substrat ;
- une structure de support (HO) pour supporter le système de projection (PL) ; et
- des moyens de mesure (MM) construits et agencés pour mesurer un mouvement du faisceau de projection (PB) sensiblement perpendiculaire à sa direction de propagation par rapport au système de projection (PL) en mesurant le mouvement relatif de la structure de support de système de rayonnement (HP) et la structure de support de système de projection (HO), **caractérisé en ce qu'**il comporte des moyens de commande (CM) construits et agencés pour commander l'intensité dudit faisceau de projection sur une partie cible du substrat en réponse à une sortie desdits moyens de mesure.

**2.** Appareil de projection lithographique selon la revendication 1, dans lequel ladite structure de support (MT) et ladite table de substrat (WT) sont mobiles dans une direction de balayage qui est sensiblement perpendiculaire à la direction de propagation, et lesdits moyens de mesure (MM) sont adaptés pour mesurer des mouvements dudit faisceau de projection (PB) dans une direction correspondant à ladite direction de balayage.

**3.** Appareil lithographique selon la revendication 2, dans lequel lesdits moyens de commande (CM) sont adaptés pour commander le mouvement de ladite structure de support (MT) et de ladite table de substrat (WT) dans la direction de balayage.

**4.** Appareil de projection lithographique selon la revendication 1, dans lequel ledit faisceau de projection (PB) comporte des impulsions (TS) de rayonnement rayonnées à une fréquence de répétition et lesdits moyens de commande (CM) sont adaptés pour régler ladite fréquence de répétition.

**5.** Appareil de projection lithographique selon la revendication 1, dans lequel ledit faisceau de projection (PB) de rayonnement comporte des impulsions (TS) de rayonnement ayant une énergie par impulsion et lesdits moyens de commande (CM) sont adaptés pour régler l'énergie par impulsion.

**6.** Appareil de projection lithographique selon la revendication 1, dans lequel lesdits moyens de commande (CM) comportent au moins un actionneur (AC) pour régler la position par rapport à un point de référence associé au système de projection d'au moins un composant sélectionné parmi le groupe de composants comportant le système de rayonnement (Ex, IL), une source (LA) pour délivrer un faisceau de projection au système de rayonnement, un élément optique (PL) du système de rayonnement, un cadre de support (HO) pour tenir le système de rayonnement, un cadre de support (HP) pour tenir ladite source, et un cadre de support (HO) pour tenir le système de rayonnement et ladite source.

**7.** Appareil de projection lithographique selon l'une quelconque des revendications 1 à 6, dans lequel lesdits moyens de mesure (MM) sont adaptés pour mesurer un mouvement par rapport à un point de référence associé audit système de projection d'au moins un composant sélectionné parmi le groupe de composants comportant le système de rayonnement (Ex, IL), une source (LA) pour délivrer un faisceau de projection au système de rayonnement, un cadre de support (HO) pour tenir le système de rayonnement, un cadre de support (HP) pour tenir ladite source, et un cadre de support (HO) pour tenir le système de rayonnement et ladite source.

**8.** Appareil de projection lithographique selon l'une quelconque des revendications 1 à 7, dans lequel lesdits moyens de mesure (MM) comportent des moyens de mesure d'accélération.

**9.** Appareil de projection lithographique selon l'une quelconque des revendications 1 à 3, dans lequel lesdits moyens de mesure (MM) comportent des moyens de mesure d'intensité (IM) pour mesurer l'intensité dudit faisceau de projection.

**10.** Appareil de projection lithographique selon l'une quelconque des revendications 6 à 9, dans lequel lesdits moyens de commande (CM) sont adaptés pour calculer une position future dudit faisceau de projection et ont un signal de déclenchement d'impulsions (TM) en tant que sortie pour déclencher un faisceau de projection depuis une source de rayonnement pulsée.

**11.** Appareil de projection lithographique selon la revendication 10, dans lequel ledit appareil comporte un dispositif de mémorisation de données relié auxdits moyens de mesure (MM) et auxdits moyens de commande (CM), pour mémoriser des informations concernant l'intensité et la position dudit faisceau de projection durant des impulsions déjà rayonnées.

**12.** Appareil selon l'une quelconque des revendications 1 à 11, dans lequel la structure de support comporte une table de masque (MT) pour tenir un masque (MA).

**13.** Appareil selon l'une quelconque des revendications 1 à 12, dans lequel le système de rayonnement (Ex, IL) comporte une source de rayonnement (LA).

**14.** Procédé de fabrication de dispositif comportant les étapes consistant à :

   - fournir un substrat (W) qui est au moins partiellement couvert d'une couche d'un matériau sensible au rayonnement ;

- délivrer un faisceau de projection (PB) de rayonnement ayant une direction de propagation en utilisant un système de rayonnement (Ex, IL) supporté par une structure de support (HP) ;

- utiliser des moyens de formation de motif (MA) pour doter le faisceau de projection d'un motif dans sa coupe transversale ;

- projeter le faisceau de rayonnement doté d'un motif sur une partie cible (C) de la couche de matériau sensible au rayonnement en utilisant un système de projection (PL) supporté par une structure de support (HO) ;

- mesurer les mouvements de la structure de support de système de rayonnement (HO) par rapport à la structure de support de système de projection (HP) par des moyens de mesure (MM) ; **caractérisé par** la transmission de la sortie des moyens de mesure à des moyens de commande (CM) agencés pour régler l'intensité dudit faisceau de projection en réponse à une sortie desdits moyens de mesure.

Fig.1.

## Fig.2.

# Fig.3.